# EUROPÄISCHE PATENTANMELDUNG

(11) **EP 2 618 640 A2**
(43) Veröffentlichungstag der Anmeldung: **24.07.2013**
(21) Anmeldenummer: 13152319.3
(22) Anmeldetag: 23.01.2013
(51) Int. Cl.: H05H 1/46

(54) **Verfahren und Vorrichtung zum Erzeugen von Plasmapulsen**

(30) Priorität: 23.01.2012 DE 102012200878
(71) Anmelder: Forschungsverbund Berlin e.V., 12489 Berlin (DE)
(72) Erfinder: Gesche, Roland, 63500 Seligenstadt (DE)
(74) Vertreter: Gulde Hengelhaupt Ziebig & Schneider

(57) **Zusammenfassung**

Die Erfindung betrifft ein Verfahren und eine Vorrichtung zum Erzeugen von Plasmapulsen sowie ein entsprechendes computerlesbares Speichermedium, welche insbesondere einsetzbar sind, um eine dreidimensionale Plasmabehandlung mit hoher Präzision auszuführen.

Das Verfahren zum Erzeugen von Plasmapulsen ist dadurch gekennzeichnet, dass mindestens zwei Quellen mit mindestens einer Zeitfunktion beaufschlagt werden, wobei die mindestens zwei Quellen jeweils ein von einer der Zeitfunktionen erzeugtes elektro-magnetisches Feld abstrahlen und die mindestens eine Zeitfunktion und die mindestens zwei Quellen derart zusammenwirken, dass in mindestens zwei vorgegebenen Raum-Zeit-Punkten mindestens eine vorgegebene Feldstärke sequentiell in zeitlicher Abfolge realisiert wird. Ein alternatives Verfahren sieht mindestens eine Quelle und mindestens ein Reflexionselement vor zur Realisierung der vorgegebenen Feldstärke.

Die Vorrichtung zum Erzeugen von Plasmapulsen umfasst mindestens zwei Quellen und mindestens eine Datenverarbeitungseinrichtung oder mindestens eine Quelle, mindestens ein Reflexionselement und mindestens eine Datenverarbeitungseinrichtung und ist derart konfiguriert, dass ein Verfahren zum Erzeugen von Plasmapulsen ausführbar ist.

## Beschreibung

Die Erfindung betrifft ein Verfahren und eine Vorrichtung zum Erzeugen von Plasmapulsen, welche insbesondere einsetzbar sind, um eine dreidimensionale Plasmabehandlung mit hoher Präzision auszuführen.

Niedertemperaturplasmen finden im Niederdruck oder an Atmosphäre vielfältige Anwendungen in einer Vielzahl von unterschiedlichen Konfigurationen. Ein immer wiederkehrendes Problem ist dabei, eine gewünschte räumliche Verteilung bzw. Gleichmäßigkeit des Plasmas bzw. dessen Produkte zu erzielen. Besonders tritt das Problem zu Tage, wenn großflächige Werkstücke oder dreidimensionale Formen behandelt werden sollen.

Ein Verfahren zur Fokussierung von Mikrowellen in einer räumlichen Position im Bereich der Medizin ist aus der Veröffentlichung WO 2006/119379 A1 bekannt. Nach dieser Vorgehensweise wird von einer Antenne eine Mikrowelle in Richtung der zu behandelnden Region ausgestrahlt. Die von der Region zurückgeworfenen Signale werden von weiteren Antennen eines Antennenarrays empfangen und durch eine Auswerteeinheit ausgewertet. Zur Behandlung der Region werden die zeitlich invertierten Mikrowellen durch das Antennenarray abgestrahlt. Nachteilig an dieser Lösung ist, dass damit nur statische Regionen behandelt werden können.

Auf dem Gebiet der Erfindung ist weiter aus der deutschen Offenlegungsschrift DE 100 18 879 A1 ein Stromversorgungsgerät zur bipolaren Stromversorgung bekannt. Das Stromversorgungsgerät umfasst zwei Schalteinheiten, mit deren Hilfe Ausgangsimpulse einer vorgebbaren Amplitude, einer vorgebbaren Pulsdauer und eines vorgebbaren Abstand zwischen den Pulsen erzeugt werden kann. Eine Überlagerung der Ausgangspulse zur Erzeugung einer vorgebbaren örtlichen Feldstärke wird durch DE 100 18 879 A1 nicht beschrieben, vielmehr wird eine geometrische Entwicklung des Plasmas durch eine spezielle Anordnung der Elektroden erreicht.

Eine Schaltungsanordnung für ein Stromversorgungsgerät für Geräte und Anlagen der Plasma- und Oberflächentechnik wird in dem Gebrauchsmuster DE 92 10 382 U1 beschrieben. Über eine Regelung der Ausgangsimpulse wird Verteilung des Plasmas optimiert. Es handelt sich um ein ausgedehntes Volumenplasma, nicht aber um eine lokale Plasmaanregung.

Die Patentschrift US 5,932,116 A betrifft eine Stromversorgung für die Impulsabgabe durch mehrere Elektroden. Gemäß dieser Druckschrift werden die Elektroden sequenziell angesteuert und wirken nicht gemeinsam auf eine lokale Behandlungsstelle.

Die europäische Patentschrift EP 0 674 369 B1 betrifft einen Gaslaser mit Mikrowellenanregung. Dabei wird ein Gasmedium durch eine Vielzahl von Mikrowellen auf einen hohen Energiezustand angeregt. Dabei unterscheiden sich die Richtungen der Schwingungen des elektrischen Feldes der Mikrowellen voneinander. Weiter weisen die Mikrowellen Impulsmikrowellen auf, die durch den Gaslaser synchronisiert werden.

Ein Gerät zur Erzeugung von Mikrowellenplasma wird in der europäischen Patentanmeldung EP 0 503 082 A1 offenbart. Das Gerät strahlt Mikrowellen in einen Entladungsraum ab, um Plasma in einem weiten Bereich an festen Positionen und über einen langen Zeitraum zu generieren. Hierfür werden von einer Vielzahl von Mikrowellensendern kontinuierlich Mikrowellenpulse in verschiedenen Zeittakten abgegeben.

Die Aufgabe der Erfindung besteht somit darin, ein Verfahren und eine Anordnung zum Erzeugen von Plasmapulsen bereitzustellen, welche die Nachteile der bekannten Lösungen beheben sowie insbesondere eine dreidimensional steuerbare Plasmabehandlung ermöglichen.

Diese Aufgabe wird erfindungsgemäß durch die Merkmale in den Ansprüchen 1, 3 und 7 gelöst. Zweckmäßige Ausgestaltungen der Erfindung sind in den Unteransprüchen enthalten.

Ein besonderer Vorteil der Erfindung besteht darin, dass auch großflächige Werkstücke oder dreidimensionale Formen mit hoher Präzision behandelt werden können, indem eine zeitliche und räumliche konstruktive Überlagerung elektromagnetischer Felder realisiert wird. Das wird dadurch erreicht, indem bei dem erfindungsgemäßen Verfahren zum Erzeugen von Plasmapulsen mindestens zwei Quellen von elektromagnetischen Feldern mit mindestens einer Zeitfunktion beaufschlagt werden, so dass die mindestens zwei Quellen jeweils ein durch die mindestens eine Zeitfunktion moduliertes elektro-magnetisches Feld abstrahlen. Insbesondere ist vorgesehen, dass es sich bei den Quellen um Antennen handelt. Die mindestens zwei Quellen sind in einer bestimmten Konfiguration angeordnet und die mindestens eine Zeitfunktion ist so ausgelegt, dass sich die von den Quellen abgestrahlten elektro-magnetischen Felder derart überlagern, so dass sich ein vorgegebenes Überlagerungsmuster ergibt. Insbesondere ist vorgesehen, dass durch das aus der Überlagerung resultierende elektro-magnetische Feld an vorgegebenen räumlichen Positionen und zu vorgegebenen Zeiten eine vorgegebene Feldstärke realisiert wird. Ein Quadrupel aus drei räumlichen Koordinaten und einem Zeitwert wird im Folgenden auch als Raum-Zeit-Punkt bezeichnet.

In einer bevorzugten Ausführungsform ist dabei vorgesehen, dass mindestens zwei Quellen mit mindestens einer Zeitfunktion beaufschlagt werden und die mindestens zwei Quellen jeweils ein von einer der Zeitfunktionen erzeugtes elektro-magnetisches Feld abstrahlen, wobei die mindestens eine Zeitfunktion und die mindestens zwei Quellen derart zusammenwirken, dass in mindestens einem vorgegebenen Raum-Zeit-Punkt ein lokal begrenzter Plasmapuls erzeugt wird, indem in dem vorgegebenen Raum-Zeit-Punkt eine vorgegebene Feldstärke realisiert wird.

Es kann dabei vorgesehen sein, dass zumindest ein Teil der Quellen mit derselben Zeitfunktion beaufschlagt wird und/oder zumindest ein Teil der Quellen mit verschiedenen Zeitfunktionen beaufschlagt werden.

In einer bevorzugten Ausführungsform ist vorgesehen, dass zumindest ein Teil der vorgegebenen Raum-Zeit-Punkte jeweils von mindestens einer der Zeitfunktionen auf verschiedenen Ausbreitungsrichtungen erreicht wird. Dies kann beispielsweise dadurch geschehen, dass mindestens eine Zeitfunktion durch ein oder mehrere Reflektionselemente reflektiert wird.

Eine alternative Ausführungsform der Erfindung sieht daher vor, die Anzahl der Quellen zu reduzieren und mindestens eine Quelle mit mindestens einer Zeitfunktion zu beaufschlagen. Die mindestens eine Quelle strahlt ein durch die mindestens eine Zeitfunktion moduliertes elektro-magnetisches Feld ab. Gemäß dieser erfindungsgemäßen alternativen Ausführungsform werden ein oder mehrere Reflektionselemente derart ausgestaltet und platziert, dass durch Überlagerung des von der mindestens einen Quelle abgestrahlten elektro-magnetischen Feldes mit reflektierten Anteilen des elektro-magnetischen Feldes in mindestens einem vorgegebenen Raum-Zeit-Punkt mindestens eine vorgegebene Feldstärke realisiert wird. In einer bevorzugten Ausführungsform ist vorgesehen, dass die Reflektionselemente Bestandteil eines Behandlungsraumes sind, beispielsweise durch zumindest einen Teil der Wände des Behandlungsraums gebildet werden.

Eine bevorzugte Ausführungsform sieht dabei vor, dass mindestens eine Quelle mit einer Zeitfunktion beaufschlagt wird und die mindestens eine Quelle ein von der Zeitfunktion erzeugtes elektro-magnetisches Feld abstrahlt, wobei die Zeitfunktion, die mindestens eine Quelle und mindestens ein Reflexionselement derart zusammenwirken, dass durch Überlagerung des abgestrahlten elektro-magnetischen Feldes mit reflektierten Anteilen des elektro-magnetischen Feldes in mindestens einem vorgegebenen Raum-Zeit-Punkt ein lokal begrenzter Plasmapuls erzeugt wird, indem in dem vorgegebenen Raum-Zeit-Punkt eine vorgegebene Feldstärke realisiert wird.

In einer weiteren bevorzugten Ausführungsform ist vorgesehen, dass sich Frequenz und/oder Amplitude zumindest eines Teils der Zeitfunktionen zeitlich ändern. Damit wird erreicht, dass sich das Überlagerungsmuster zeitlich ändert und somit eine Vielzahl von Einzelplasmapulsen von vorgegebener Feldstärke nacheinander an verschiedenen Orten des (dreidimensionalen) Raumes erzeugt wird. Dabei kann die Feldstärke variieren und an zumindest einem Teil der verschiedenen Orte verschiedene Werte annehmen. Auf diese Weise lassen sich auch komplexe ein-, zwei- oder dreidimensionale räumliche Strukturen bzw. Muster erzeugen, beispielsweise für eine Behandlung von Materialien. Insbesondere ist vorgesehen, einen oder mehrere Plasmapulse in zeitlicher Abfolge nacheinander sequentiell an verschiedenen räumlichen Zielorten zu generieren.

Eine andere bevorzugte Ausführungsform sieht vor, dass zumindest ein Teil der Zeitfunktionen ermittelt wird, indem an den räumlichen Zielorten, d.h. an den Orten, an denen ein Plasmapuls einer vorgegebenen Feldstärke erzeugt werden soll, ein Puls mit entsprechender Feldstärke abgegeben wird. Die Antwort dieses abgegebenen Pulses wird an den Orten der Quelle bzw. der Quellen aufgezeichnet. Für zumindest einen Teil der Quellen, vorzugsweise für jede der Quellen, wird so eine Zeitfunktion aufgezeichnet. Um den Plasmapuls an dem Zielort zu erzeugen, werden die so ermittelten Zeitfunktionen durch die Quelle bzw. die Quellen zeitlich invertiert (wieder) abgestrahlt. Auf diese Weise lassen sich Plasmapulse auch in komplexen Umgebungen, beispielsweise bei komplex angeordneten Reflexionselementen, gewinnen. Alternativ dazu ist es auch möglich, die Zeitfunktionen direkt zu berechnen oder durch eine Simulation zu gewinnen.

Eine erfindungsgemäße Vorrichtung zum Erzeugen von Plasmapulsen umfasst zumindest zwei Quellen von elektro-magnetischen Wellen und mindestens eine Datenverarbeitungseinrichtung. Die Vorrichtung ist erfindungsgemäß so konfiguriert, dass die zumindest zwei Quellen mit mindestens einer Zeitfunktion beaufschlagt werden, wobei die zumindest zwei Quellen jeweils ein durch die mindestens eine Zeitfunktion moduliertes elektro-magnetisches Feld abstrahlen. Die Anordnung der zumindest zwei Quellen und der mindestens einen Zeitfunktion sind so aufeinander abgestimmt, dass an mindestens einem vorgegebenen Ort im dreidimensionalen Raum zu einer vorgegebenen Zeit (vorgegebener Raum-Zeit-Punkt) ein Plasmapuls von vorgegebener Feldstärke erzeugt wird. Vorzugsweise wird ein lokal begrenzter Plasmapuls erzeugt, indem in dem vorgegebenen Raum-Zeit-Punkt eine vorgegebene Feldstärke realisiert wird.

In einer bevorzugten Ausführungsform ist vorgesehen, dass die Vorrichtung weiterhin mindestens ein Reflexionselement umfasst, an dem die von zumindest einem Teil der mindestens zwei Quellen abgestrahlten elektro-magnetischen Wellen reflektiert werden. In diesem Fall wirken die zumindest zwei Quellen, das mindestens eine Reflexionselement und die mindestens eine Zeitfunktion derart zusammen, dass an mindestens einem vorgegebenen Raum-Zeit-Punkt ein Plasmapuls von vorgegebener Feldstärke erzeugt wird. Bei Verwendung des mindestens einen Reflexionselements ist es ausreichend, wenn die Vorrichtung neben dem mindestens einen Reflexionselement nur mindestens eine Quelle und mindestens eine Datenverarbeitungseinrichtung umfasst, um den Plasmapuls von vorgegebener Feldstärke zu erzeugen.

Vorzugsweise ist zumindest ein Teil der Quellen als Antennen ausgebildet. Eine bevorzugte Ausführungsform sieht vor, dass auch der Puls, der zur Ermittlung des zumindest einen Teils der Zeitfunktionen abgegeben wird, durch eine Antenne abgegeben wird.

In einer weiteren bevorzugten Ausführungsform ist vorgesehen, dass die Vorrichtung weiter einen Behandlungsraum umfasst. Vorzugsweise ist zumindest ein Teil der Wände des Behandlungsraumes als Reflexionselement ausgebildet. Vorzugsweise weist zumindest ein Teil der Innenwände des Behandlungsraumes eine metallische Oberfläche auf.

In weiteren bevorzugten Ausführungsformen ist die Vorrichtung so konfiguriert, dass die in der Beschreibung erläuterten Verfahrensschritte ausführbar sind.

Ein Computerprogramm nach der Erfindung ermöglicht es einer Datenverarbeitungseinrichtung, nachdem es in den Speicher der Datenverarbeitungseinrichtung geladen worden ist, ein Verfahren zum Erzeugen von Plasmapulsen auszuführen, wobei mindestens zwei Quellen mit mindestens einer Zeitfunktion beaufschlagt werden, die mindestens zwei Quellen jeweils ein von einer der Zeitfunktionen erzeugtes elektro-magnetisches Feld abstrahlen und die mindestens eine Zeitfunktion und die mindestens zwei Quellen derart zusammenwirken, dass in mindestens zwei vorgegebenen Raum-Zeit-Punkten mindestens eine vorgegebene Feldstärke sequentiell in zeitlicher Abfolge realisiert wird.

Ein alternatives Computerprogramm nach der Erfindung ermöglicht es einer Datenverarbeitungseinrichtung, nachdem es in den Speicher der Datenverarbeitungseinrichtung geladen worden ist, ein Verfahren zum Erzeugen von Plasmapulsen auszuführen, wobei mindestens eine Quelle mit einer Zeitfunktion beaufschlagt wird, die mindestens eine Quelle ein von der Zeitfunktion erzeugtes elektro-magnetisches Feld abstrahlt und die Zeitfunktion, die mindestens eine Quelle und mindestens ein Reflexionselement derart zusammenwirken, dass durch Überlagerung des abgestrahlten elektro-magnetischen Feldes mit reflektierten Anteilen des elektro-magnetischen Feldes in mindestens einem vorgegebenen Raum-Zeit-Punkt mindestens eine vorgegebene Feldstärke realisiert wird.

Solche Computerprogramme können beispielsweise (gegen Gebühr oder unentgeltlich, frei zugänglich oder passwortgeschützt) downloadbar in einem Daten- oder Kommunikationsnetz bereitgestellt werden. Die so bereitgestellten Computerprogramme können dann durch ein Verfahren nutzbar gemacht werden, bei dem ein Computerprogramm aus einem elektronischen Datennetz, wie beispielsweise aus dem Internet, auf eine an das Datennetz angeschlossene Datenverarbeitungseinrichtung heruntergeladen wird.

Um das erfindungsgemäße Verfahren durchzuführen, ist vorgesehen, ein computerlesbares Speichermedium einzusetzen, auf dem ein Programm gespeichert ist, das es einer Datenverarbeitungseinrichtung ermöglicht, nachdem es in den Speicher der Datenverarbeitungseinrichtung geladen worden ist, ein Verfahren zum Erzeugen von Plasmapulsen durchzuführen, wobei mindestens zwei Quellen mit mindestens einer Zeitfunktion beaufschlagt werden, wobei die mindestens zwei Quellen jeweils ein von einer der Zeitfunktionen erzeugtes elektro-magnetisches Feld abstrahlen und die mindestens eine Zeitfunktion und die mindestens zwei Quellen derart zusammenwirken, dass in mindestens zwei vorgegebenen Raum-Zeit-Punkten mindestens eine vorgegebene Feldstärke sequentiell in zeitlicher Abfolge realisiert wird.

Alternativ ist ein computerlesbares Speichermedium vorgesehen, auf dem ein Programm gespeichert ist, das es einer Datenverarbeitungseinrichtung ermöglicht, nachdem es in den Speicher der Datenverarbeitungseinrichtung geladen worden ist, ein Verfahren zum Erzeugen von Plasmapulsen durchzuführen, wobei mindestens eine Quelle mit einer Zeitfunktion beaufschlagt wird, die mindestens eine Quelle ein von der Zeitfunktion erzeugtes elektro-magnetisches Feld abstrahlt und die Zeitfunktion, die mindestens eine Quelle und mindestens ein Reflexionselement derart zusammenwirken, dass durch Überlagerung des abgestrahlten elektromagnetischen Feldes mit reflektierten Anteilen des elektro-magnetischen Feldes in mindestens einem vorgegebenen Raum-Zeit-Punkt mindestens eine vorgegebene Feldstärke realisiert wird. Vorzugsweise wird ein lokal begrenzter Plasmapuls erzeugt, indem in dem vorgegebenen Raum-Zeit-Punkt eine vorgegebene Feldstärke realisiert wird.

Insbesondere ist vorgesehen, dass die mindestens eine Zeitfunktion durch die Datenverarbeitungseinrichtung erzeugt wird. Vorzugsweise handelt es sich bei der Datenverarbeitungseinrichtung um einen Controller.

Die Erfindung löst somit das Problem, eine gewünschte räumliche Verteilung (insbesondere eine gleichmäßige Verteilung) eines Plasmas zu erzielen, indem durch elektrische Felder einzelne, zeitlich kurze und lokal scharf begrenzte Plasmapulse erzeugt werden, deren Intensität und Lokalisierung durch eine erfindungsgemäße elektrische Versorgungseinrichtung gesteuert werden kann. Eine Vielzahl solcher Einzelpulse wird nacheinander erzeugt, deren Summe formt eine dreidimensional steuerbare Plasmabehandlung.

Dieses Konzept kann auch für andere Anwendungen als die Plasmaanregung verwendet werden, wo durch hohe lokale Feldstärken eine Behandlungswirkung erzeugt wird, z. B. zur Erwärmung von Materialien.

Die Erfindung wird nachfolgend unter Bezugnahme auf die Zeichnung an einem Ausführungsbeispiel näher erläutert. Es zeigt:

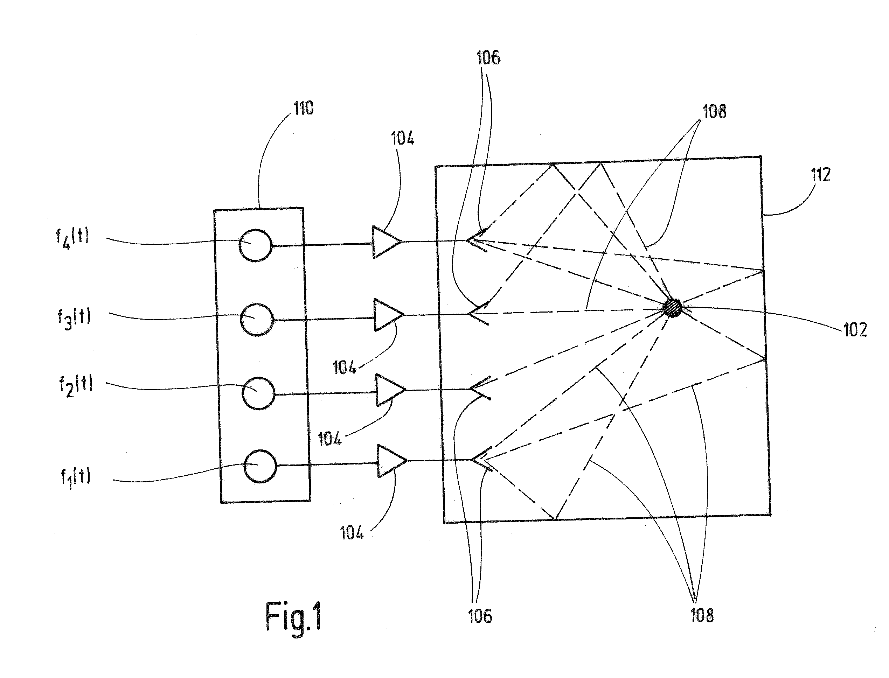

- Figur 1: eine prinzipielle Veranschaulichung eines beispielhaften Verfahrens zur Erzeugung von Plasmapulsen.

Nachfolgend wird die Erfindung beispielhaft an einem Ausführungsbeispiel mit vier Antennen als Quellen und einem Behandlungsraum, dessen Wände als Reflexionselemente wirken, näher beschrieben. Es wird jedoch betont, dass die Erfindung nicht auf das spezielle Ausführungsbeispiel eingeschränkt ist, sonder ebenso Verfahren und Vorrichtungen mit umfasst, welche eine andere Anzahl von Antennen, insbesondere nur eine Antenne, umfassen. Ebenso umfasst die Erfindung auch Verfahren und Vorrichtungen, die eine andere Anzahl von Reflexionselementen oder anders gestaltete Reflexionselemente nutzen oder kein Reflexionselement aufweisen.

Kern der Erfindung ist die zeitliche und räumliche Überlagerung elektro-magnetischer Felder, die in einem räumlichen Zielpunkt 102 zu einer gewünschten Zeit einen Puls einer gewünschten Feldstärke erzeugen. Dabei werden aus einem oder mehreren Leistungsverstärkern 104 und Antennen 106 Zeitfunktionen abgegeben, die den Zielpunkt 102 auf einem oder verschiedenen Ausbreitungswegen 108 erreichen.

Gemäß der beispielhaften Ausführungsform werden vier Zeitfunktionen f₁(t), f₂(t), f₃(t) und f₄(t) von einem Controller 110 erzeugt. Bei den Zeitfunktionen f₁(t), f₂(t), f₃(t) und f₄(t) kann es sich um zeitlich modulierte Trägerfrequenzen handeln. Diese Signale werden von den Leistungsverstärkern 104 verstärkt und über die Antennen in einem Behandlungsraum 112 abgestrahlt. In der beispielhaften Ausführungsform ist der Behandlungsraum 112 als Kammer mit metallischen Wänden ausgebildet. Indem die elektro-magnetischen Wellen an den metallischen Wänden des Behandlungsraums 112 reflektiert werden, entsteht eine Vielzahl von Ausbreitungswegen 108, die bei geeigneten Zeitfunktionen f₁(t), f₂(t), f₃(t) und f₄(t) zu der gewünschten Überlagerung führen.

Zur Bestimmung der Zeitfunktionen f₁(t), f₂(t), f₃(t) und f₄(t) kann z. B. eine zusätzliche Antenne am Zielpunkt 102 in dem Behandlungsraum 112 angeordnet sein. Über die zusätzliche Antenne wird ein Puls der gewünschten Feldstärke abgegeben und die Antwort von den Antennen 106 aufgezeichnet. Wird diese Pulsantwort zeitlich invertiert von dem Controller 110 erzeugt, so entsteht am Zielpunkt 102 wieder der ursprüngliche Puls. Dieses verfahren ist als "Zeitumkehr" bekannt und findet beispielsweise in der Akustik oder der Medizintechnik Anwendung.

Die Erfindung beschränkt sich in ihrer Ausführungsform nicht auf die vorstehend angegebenen bevorzugten Ausführungsbeispiele. Vielmehr ist eine Anzahl von Varianten denkbar, die von der erfindungsgemäßen Vorrichtung, dem erfindungsgemäßen Verfahren und dem erfindungsgemäßen computerlesbaren Speichermedium auch bei grundsätzlich anders gearteten Ausführungen Gebrauch machen.

## Patentansprüche

1. Verfahren zum Erzeugen von Plasmapulsen,
**dadurch gekennzeichnet, dass**
mindestens zwei Quellen mit mindestens einer Zeitfunktion beaufschlagt werden, wobei die mindestens zwei Quellen jeweils ein von einer der Zeitfunktionen erzeugtes elektro-magnetisches Feld abstrahlen und die mindestens eine Zeitfunktion und die mindestens zwei Quellen derart zusammenwirken, dass in mindestens zwei vorgegebenen Raum-Zeit-Punkten mindestens eine vorgegebene Feldstärke sequentiell in zeitlicher Abfolge realisiert wird.

2. Verfahren nach Anspruch 1,
**dadurch gekennzeichnet, dass**
der mindestens eine vorgegebene Raum-Zeit-Punkt von mindestens einer der Zeitfunktionen auf mindestens zwei verschiedenen Ausbreitungswegen (108) erreicht wird.

3. Verfahren zum Erzeugen von Plasmapulsen,
**dadurch gekennzeichnet, dass**
mindestens eine Quelle mit einer Zeitfunktion beaufschlagt wird, wobei die mindestens eine Quelle ein von der Zeitfunktion erzeugtes elektro-magnetisches Feld abstrahlt und
die Zeitfunktion, die mindestens eine Quelle und mindestens ein Reflexionselement derart zusammenwirken, dass durch Überlagerung des abgestrahlten elektro-magnetischen Feldes mit reflektierten Anteilen des elektro-magnetischen Feldes in mindestens einem vorgegebenen Raum-Zeit-Punkt mindestens eine vorgegebene Feldstärke realisiert wird.

4. Verfahren nach einem der vorhergehenden Ansprüche,
**dadurch gekennzeichnet, dass**
die vorgegebenen Raum-Zeit-Punkte eine ein-, zwei- oder dreidimensionale Struktur bilden.

5. Verfahren nach einem der vorhergehenden Ansprüche,
**dadurch gekennzeichnet, dass**
mindestens eine Zeitfunktion dadurch ermittelt wird, dass an einem RaumPunkt ein vorgegebener Puls abgegeben und an den Orten der mindestens zwei Quellen als Pulsantwort aufgezeichnet wird.

6. Verfahren Anspruch 5,
**dadurch gekennzeichnet, dass**
mindestens eine Quelle mit der zeitlich invertierten Pulsantwort beaufschlagt wird.

7. Vorrichtung zum Erzeugen von Plasmapulsen, wobei die Vorrichtung mindestens zwei Quellen und mindestens eine Datenverarbeitungseinrichtung oder
mindestens eine Quelle, mindestens ein Reflexionselement und mindestens eine Datenverarbeitungseinrichtung
umfasst, und wobei die Vorrichtung derart konfiguriert ist, dass ein Verfahren zum Erzeugen von Plasmapulsen gemäß einem der Ansprüche 1 bis 5 ausführbar ist.

8. Vorrichtung nach Anspruch 7,
**dadurch gekennzeichnet, dass**
zumindest ein Teil der Quellen als Antenne (106) ausgebildet ist.

9. Vorrichtung nach Anspruch 7 oder 8,
**dadurch gekennzeichnet, dass**
die Vorrichtung weiter mindestens einen Behandlungsraum (112) umfasst und zumindest ein Teil der Wände des Behandlungsraums (112) das mindestens eine Reflexionselement bildet und/oder
dass zumindest ein Teil der Reflexionselemente eine metallische Oberfläche aufweist.

10. Computerlesbares Speichermedium, auf dem ein Programm gespeichert ist, das es einer Datenverarbeitungseinrichtung im Zusammenwirken mit mindestens zwei Quellen oder mit mindestens einer Quelle und mindestens einem Reflexionselement ermöglicht, nachdem das Programm in Speichermittel der Datenverarbeitungseinrichtung geladen worden ist, ein Verfahren zum Erzeugen von Plasmapulsen gemäß einem der Ansprüche 1 bis 6 durchzuführen.
